# EUROPEAN PATENT APPLICATION

(11) **EP 0 594 372 A2**
(43) Date of publication of application: **27.04.1994**
(21) Application number: 93308239.8
(22) Date of filing: 15.10.1993
(51) Int. Cl.: H01R 13/658, H01R 4/64, H05K 9/00

(54) **Improvements in and relating to terminating shielded cables**

(30) Priority: 17.10.1992 GB 9221949; 13.09.1993 GB 9318995
(71) Applicant: Pitchford, Garry, Mansfield, Nottinghamshire NG19 7HX (GB)
(72) Inventor: Pitchford, Garry, Mansfield, Nottinghamshire NG19 7HX (GB)
(74) Representative: Attfield, Donald James

(57) **Abstract**

A method and apparatus for terminating shielded cables (12) are provided in which the braid (14) provided on the cable (12) is arranged over the outside of a member (1) which transits a hole in the enclosure. The member (1) provides the entry for the cable (12), but the electrical continuity between the braid (14) member (1) and an electrically conducting surface (10) of the wall (8) of the enclosure ensure effective electromagnetic induction shielding.

In a preferred embodiment the braid (14) passes into the enclosure and is folded back over the member (1).

The apparatus and method provide for quicker and cheaper shielding than previous techniques.

To be accompanied when published by Figure 5 of the drawings.

## Description

This invention relates to a method and apparatus for terminating shielded cables, in particular, but not exclusively, to shielding cable entries to electromagnetic shielded enclosures.

It is a particular object of the invention to provide for a quick, simple, aesthetic, cheap and effective method and apparatus for achieving such shielding.

It is necessary to ground cables with a braided shield to the wall of an enclosure for an enclosure which has an electromagnetic interference (EMI) shielded capability when that cable passes through the wall of the enclosure, otherwise the enclosure will lose its ability to maintain its shielding effectiveness. The technology to do this is well understood and has been a requirement in Aerospace and Defence industries for many years. The methods of terminating the cable shield braid and supporting the cable have traditionally been both functional and robust. However, there are now pending EEC regulations requiring commercial electrical goods manufacturers to have an EMI shielding capability. The military solutions are costly, time consuming in installation, bulky and unsightly.

According to a first aspect of the invention, means for terminating cable shielded by a braid to an electrically conductive surface of a wall of an enclosure through which the cable transits, characterised in that it comprises a hollow member extending through the wall and includes an element to engage one face of the wall; means for retaining the element in contact with thewall; the internal dimensions of the member permitting the passage of the cable therethrough; means for securing the braid against the member; and means for providing electrical continuity between the braid and the wall.

The said element is preferably a flange and most preferably a flange which is integral with the member.

The member may be of metal, but is most preferably of a non-conductive material. Most preferably the engaging element is provided with a seal for engaging with the wall.

Preferably member retaining means to retain the element in contactwith the said one face are provided and most preferably the member retaining means act against the wall of the enclosure opposing the engaging element. The member retaining means could be adhesive applied to the engaging element.

Preferably the braid is arranged over at least a part of an exterior surface of the member.

Preferably, the shielded cable passes through the member and the braid is secured to a portion of the member extending inwardly of the enclosure, preferably by folding back over the said inner portion: ideally providing 360° termination.

Preferably the member has a portion of one internal diameter and a second portion of a reduced internal diameter, the reduced diameter portion is preferably the portion which is innermost relative to the enclosure.

The member may have a threaded, serrated or grooved exterior, most preferably on the inner portion of the member.

The member retaining means may comprise an internally threaded member for engagement with a threaded inner portion of the member and may act to trap the braid against the said portion and provide electrical contact with the said electrically conductive face.

The braid may be arranged to be electrically connected to the wall directly, via the member, retaining member, or by a gasket or any one or more of these means in combination.

According to a second aspect of the invention, a method of terminating cable shielded by a braid to an enclosure having an electrically conductive wall surface characterised in that it comprises the steps of inserting a hollow member having an engaging element through a hole in the enclosure until the engaging element engages with the enclosure; introducing means for retaining the element in contact with the wait; stripping a portion of the cable of its insulating cover and inserting the cable through the member or vice-versa; and arranging the braid over at least part of an external surface of the member such that the braid is in electrical continuity with the wall.

Retaining means may be placed over the member to fix it relative to the enclosure wall.

Preferably the braid is passed through the member and is folded back over t he external surface of the member to provide 360° termination.

Preferably the braid is then secured to the member by retaining means. Most preferably the braid retaining means and member retaining means are one and the same.

Various aspects and embodiments of the invention are illustrated, by way of example only, in the accompanying drawings in which:-
Figure 1 is a side view, with a cut-away section, of a member;
Figure 2 is a side view, with cut-away section of the member of Figure 1 in use;
Figure 3 is a side view, with a cut-away section of an alternative embodiment of a member;
Figure 4 is a side view, with a cut-away section of a retaining means for use with the member of Figure 3;
Figure 5 is a side view, with a cut-away section of the embodiment of Figures 3 and 4 in use; and
Figure 6 is a side view, with a cut-away section of a further embodiment, in use.

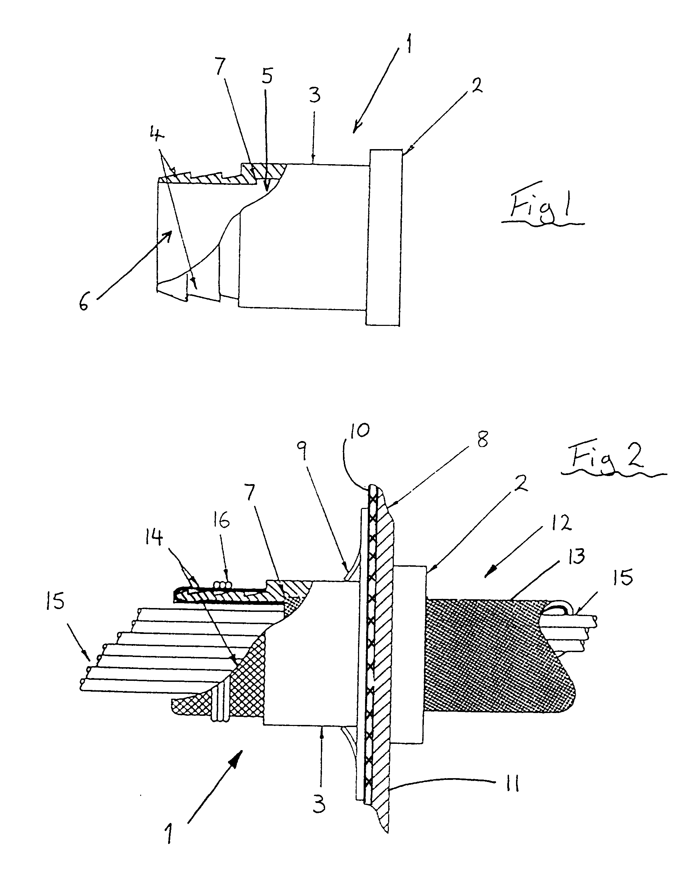

The member 1, as shown in Figure 1, is formed of an electrically conductive material such as brass and has an outer flange 2 and a tubular body portion 3. A portion 4 of the body portion 3 is serrated.

Internally the member 1 has a first part 5 of one diameter and a second part 6 of a reduced diameter. A shoulder 7 is defined at the point where the diameter of the member 1 is reduced.

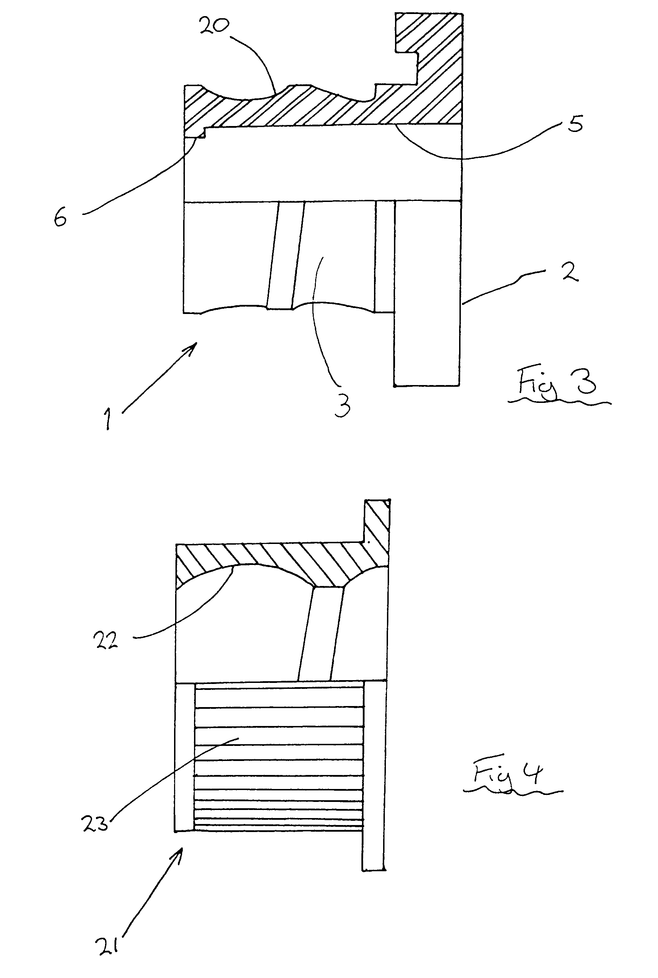

In use, as shown in Figure 2, the member 1 passes through a hole in a wall 8 of the enclosure concerned, the wall 8 having an electrically conductive face 10. The diameter of the flange 2 is such that the member 1 as a whole cannot pass through the hole. Aspring washer9, to act as retaining means, is placed over the body portion 3 and pushed up against the inner face 10 of the enclosure wall 8. The retaining member also serves to make electrical contact between the face and the member. The flange 2 abuts against the outer face of the wall 11.

A cable 12 is then introduced, with a portion of the cable's insulating cover 13 stripped away to expose the cable shield braid 14 and individual insulated wires 15, penetrating the internal diameter of the member 1.

On introduction the end of the insulating cover 13 abuts on the shoulder 7 whilst the reduced diameter is such that the insulated individual wires 15 and braid 14 pass through to the interior of the enclosure.

The cable braid 14 is stripped back from beyond the end of the body portion 3 and folded back over the external surface of the serrated portion 4 of the member 1.

The braid 14 is secured to the member 1 by means of a circular spring 16 which strives to return to its original diameter. Its original diameter being less than the external diameter of the member. The spring 16 engages with the serrated portion 4 and clamps the braid 14 ensuring a good mechanical and electrical contact between the braid 14 and the electrically conductive face 10 of the wall 8 via the member 1 and spring washer 9.

As the braid 14 is clamped around the 360° of the periphery of the member 1 the continuity of the electromagnetic shield is ensured.

As alternatives to using the spring washer9, a nut and washer, spring or other device capable of producing a force in the direction of the flange 2 and making electrical contact between the body and the conductive inner surface of the wall may be used.

Similarly, other clamping or securing devices other than the circular spring 16 may be used to trap the braid 14 such as a jubilee clip or brazing, soldering or welding.

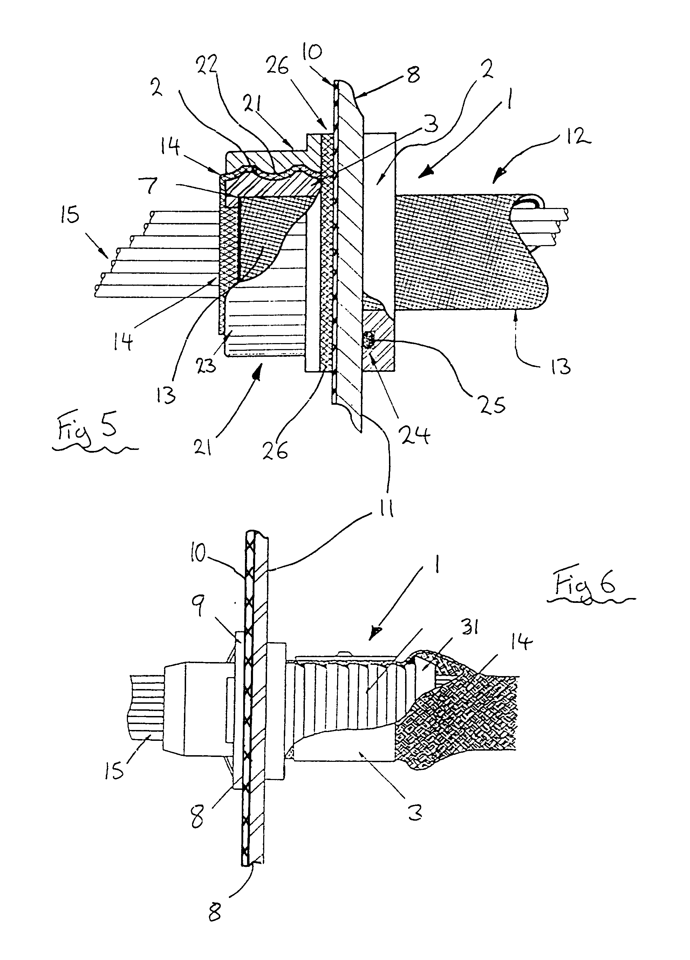

A preferred alternative embodiment of the invention is presented in Figures 3 to 5. Like elements from other embodiments are indicated by like reference numerals.

The member 1, made of an insulating plastics material such as nylon, has an outer flange 2 and a tubular body portion 3. The outer surface of the body portion 3 is provided with a coarse thread 20. The internal diameter 5 of the body portion 3 is reduced to give a slightly reduced diameter 6 very close to the end of the member opposite to the flange 2. The reduced diameter portion 6 corresponds to the diameter of braided wires 15 without its insulating cover 13, whereas the remainder of the tubular body is of such diameter as to accommodate a cable 12 with its insulating cover 13.

The retaining nut 21, illustrated in Figure 4, is provided with a coarse internal thread 22 which corresponds to the outer thread 20 of the body portion 3. The outer cylindrical surface 23 of the nut is knurled.

In use the fitting 1 is inserted through a hole in the enclosure wall 8. The hole is of such a size as to accommodate the body portion 3, but is small enough that the flange 2 prevents the entire fitting passing through.

A circular groove 24 is provided in the surface of the flange 2 which abuts with the outer wall face 11. The groove 24 accommodates an environmental seal 25 made of a compressible silicone rubber.

The cable 12 to be inserted is partially stripped of its insulating cover 13 so as to expose the insulated individual wires 15 and braid 14. The wires 15 are then passed through the fitting 1 until the insulating cover 13 abuts on the shoulder 7 defined by the reduced diameter portion 6.

A portion of the braid 14 passing into the enclosure's interior beyond the fitting 1 is then cut and stripped so that sufficient length is available to fold back over the outside of the body portion 3.

By screwing the retaining nut 21 onto the body portion 3 the braid 14 is trapped within the coarse thread 20,22.

The electromagnetic shielding of the cable 12 is ensured by the braid 14 being of sufficient length to be in electrical contact with a conductive EMI continuity gasket 26, which itself makes electrical contact with the inner surface 10 of the enclosure wall 8 by the clamping action of the retaining nut 21.

The gasket 26 may be omitted where there is sufficient length of braid 14 to contact the conductive surface 10 of the the wall 8, the retaining nut 21 compressing the braid 14 against the wall surface 10.

The retaining nut 21 in combination with the flange 2 holds the fitting 1 in position relative to the wall 8. At the same time environmental sealing is accomplished by the clamping of the seal 25. This seal 25 prevents moisture from entering the hole in the enclosure wall 8. Further environmental sealing is achieved by providing or coating the inside diameter of the hole 5,6 in the tubular body 3 with adhesives or sealants to prevent the ingress of moisture.

The fitting 1 and retaining nut 21 may be both of an insulating plastics material or metal or any other suitable material, such as ceramics. They may be of different materials as desired.

The use of plastics or other non-conducting parts for the cable entry body maintains the double insulation safety aspects of the entry into enclosures.

Figure 6 shows a further embodiment in which the braid 14 is arranged over an outer portion 31 of the member 1. The outer portion 31 is provided with serrations 32 which co-operate with a clip 33 to secure the braid 14 to the member 1. Electrical contact with the electrically conductive inner face 10 of the wall 8 for the braid 14 is ensured by way of the member 1 which is electrically conductive and contacts both the inner face 10 of the wall and the braid 14.

## Claims

1. Means for terminating cable (12) shielded by a braid (14) to an electrically conductive inner surface (10) of a wall (8) of an enclosure through which the cable (12) transits, characterised in that it comprises a hollow member (1) extending through the wall (8) and includes an element (2) to engage one face of the wall (8), means for retaining the element (2) in contactwith the wall (8), the internal dimensions of the member (1) permitting the passage of the cable (12) therethrough; means (16,21) for securing the braid (14) against the member (1); and means (1,9,26) for providing electrical continuity between the braid (14) and the surface (10) of the wall (8).

2. Means according to claim 1 in which the engaging element (2) is a flange which is integral with the member (1).

3. Means according to claim 1 or claim 2 in which the braid (14) is arranged over at least part of an exterior surface of the member (1).

4. Means according to any preceding claim in which the shielded cable (14,15) passes through the member (1) and the braid (14) is secured to a portion (3) of the member (1) extending inwardly of the enclosure.

5. Means according to any preceding claim in which the braid (14) is folded back overthe exterior surface of the inner portion of the member (1).

6. Means according to any preceding claim in which the member has a portion of one internal diameter (5) and a second portion of reduced internal diameter (6), the reduced diameter portion being the innermost relative to the enclosure.

7. Means according to any preceding claim in which the member (1) has a threaded (20), serrated (4) or grooved exterior.

8. Means according to any preceding claim in which member retaining means (9,21) are provided which act against the surface (10) of the wall (8) of the enclosure opposing the engaging element (2).

9. Means according to claim 9 in which the member retaining means (9,21) comprise an internally threaded member which engages with a threaded inner portion (20) of the member (1) and traps the braid (14) against said inner portion (20).

10. A method of terminating cable (12) shielded by a braid (14) to an enclosure having an electrically conductive surface (10) of a wall (8) characterised in that it comprises the steps of inserting a hollow member (1) having an engaging element (2) through a hole in the enclosure until the engaging element (2) engages with the enclosure; introducing means for retaining the element (2) in contact with the wall (8); stripping a portion of the cable (12) of its insulating cover (13) and inserting the cable (12) through the member(1) orvice- versa; and arranging the braid (14) over at least a part of an external surface (3) of the member (1), such that the braid (14) is in electrical continuity with the surface (10) of the wall (8).
